**Europäisches Patentamt**

**European Patent Office**

**Office européen des brevets**

(11) Publication number: **0 331 160 B1**

## EUROPEAN PATENT SPECIFICATION

(45) Date of publication of patent specification: **28.09.94**

(51) Int. Cl.5: **C04B 35/65**, C04B 35/80, H01L 41/18, H05K 1/03

(21) Application number: **89103646.9**

(22) Date of filing: **02.03.89**

(54) **Functional ceramic shaped article and process for producing the same.**

(30) Priority: **04.03.88 JP 49544/88**

(43) Date of publication of application:
**06.09.89 Bulletin 89/36**

(45) Publication of the grant of the patent:
**28.09.94 Bulletin 94/39**

(84) Designated Contracting States:
**CH DE FR GB IT LI NL SE**

(56) References cited:
**EP-A- 0 286 127**
**WO-A-87/06928**
**US-A- 4 725 456**

**DATABASE WPIL/DERWENT abstract no. 86-167152 (26),1986, Derwent Publications Ltd., London, GB; & JP -A - 61101465 (HITACHI) 20.05.1986 (cat. D)**

**DATABASE WPIL/DERWENT abstract no. 87-232760 (33),1987, Derwent Publications Ltd., London, GB; & JP -A - 62158172 (KORANSHA K.K.) 14.07.1987**

(73) Proprietor: **HITACHI, LTD.**
**6, Kanda Surugadai 4-chome**
**Chiyoda-ku, Tokyo 101 (JP)**

(72) Inventor: **Yasutomi, Yoshiyuki**
**6-1-403, Ishikawacho**
**Katsuta-shi (JP)**
Inventor: **Miyoshi, Tadahiko**
**26-9, Mikanoharacho 2-chome**
**Hitachi-shi (JP)**
Inventor: **Sobue, Masahisa**
**433-75, Yonezawacho**
**Mito-shi (JP)**

(74) Representative: **Patentanwälte Beetz - Timpe - Siegfried Schmitt-Fumian - Mayr**
**Steinsdorfstrasse 10**
**D-80538 München (DE)**

DATABASE WPIL/DERWENT abstract no. 86-275974 (42),1986, Derwent Publications Ltd., London, GB; & JP -A - 61201662 (HITACHI) 06.09.1986 (cat. D)

DATABASE WPIL/DERWENT abstract no. 88-032949 (05),1988, Derwent Publications Ltd., London, GB; & JP -A - 62292666 (TOSHIBA) 19.12.1987 (cat. D)

DATABASE WPIL/DERWENT abatract no. 86-328079 (50),1986, Derwent Publications Ltd., London, GB; & JP -A - 61242978 (AGENCY OF IND. SCI. TECH.) 29.10.1986 (cat. D)

DATABASE WPIL/DERWENT abstract no. 86-342927 (52),1986, Derwent Publications Ltd., London, GB; & JP -A - 61256906 (HITACHI) 14.11.1986 (cat. D)

DATABASE WPIL/DERWENT abstract no. 87-316397 (45),1987, Derwent Publications Ltd., London, GB; & JP -A - 62223065 (HITACHI) 01.10.1987 (cat. D)

DATABASE WPIL/DERWENT abstract no. 88-004821 (01),1988, Derwent Publications Ltd., London, GB; & JP -A - 62270481 (HITACHI) 24.11.1987 (cat. D)

CERAMIC ENGINEERING AND SCIENCE PROCEEDINGS vol. 8, nos. 7,8, July-August 1987, pages 879-885, Westerville, OH, US; M.S. NEWKIRK et al.: "Preparation of Lanxide Ceramic Matrix Composites: Matrix Formation by the Directed Oxidation of Molten Metals"

**Description**

BACKGROUND OF THE INVENTION

The present invention relates to functional ceramic shaped articles and a process for producing the same. More particularly, the invention relates to functional ceramic shaped articles which are producible by sintering shaped bodies with a small dimensional change in sintering stage and have each at least a dielectric function, the resistivity of said articles being variable with the kinds and proportions of ingredients used, and said articles being superior in oxidation resistance and corrosion resistance, and the invention also relates to a process for producing such functional ceramic shaped articles.

Recently, research and development for functional ceramic materials has been made extensively and in particular, ceramic materials having gradient functions have drawn attention. However, no satisfactory functional ceramic material has been developed up to now. There are needs today for functional ceramic materials which satisfy all of various requirements about functions, shapes simple or complicated which are fitted for a number of applications, dimensions and accuracy thereof, etc. Especially, it is contemplated to develop a shaped ceramic material not having a single function.

Japanese Patent Kokai (Laid-Open) No. 62-292666 proposes a process for producing functional ceramics which comprises normal-pressure sintering of raw material mixtures containing a sintering aid. Japanese Patent Koaki (Laid-Open) No. 61-242978 proposes a process for producing functional ceramics which comprises impregnating $Si_3N_4$ sintered bodies, which are porous products of reaction-sintering, with a biological material (material useful in living bodies) such as apatite.

On the other hand, the following several processes are proposed which, though not for producing functional ceramics, use reaction-sintering techniques to produce machine-constructing materials, i.e. the processes described in Japanese Patent Kokai (Laid-Open) Nos. 61-101465, 61-201662, 61-256906, 62-223065, and 62-270481. However, none of these patent applications disclose any reaction-sintered article having an electric or magnetic characteristic, in other words, a special function.

The first thereof, i.e. JP-A-61-101465 discloses a method for the manufacture of sintered silicon carbide based workpieces by mixing the components of the article, moulding said article in a mechanical press or injection moulding machine, heating the moulded product until the high molecular compound thermoplastic resin and the additives are decomposed and heating it subsequently in $H_2$, $N_2$ or $NH_3$.

The object of this document is to provide a material possessing high strength, thermal shock resistance, heat resistance and corrosion resistance for the use for example in an engine, turbine etc.

In general, functional materials, for example, well-known magnetic materials according to the prior art include representative magnets of Fe and Ni families, Fe-Cr-Co magnets, ferrite magnets and sintered rare earth metal-Co magnets. These magnetic materials, however, have disadvantages such as high costs, brittleness and hence liability to break, difficulties in making large-size articles, and low resistance to oxidation, corrosion, or heat. Hence, these materials are unifitted for uses in special or harsh environments.

There are bond magnets, which are developed for offsetting the above disadvantages. These magnets are formed by binding magnetic particles with plastics or synthetic rubbers. This covers the drawback of being hard and brittle, but the maximum service temperature of these magnets is 120°C or below, that is, they are inferior in heat resistance corrosion resistance, and oxidation resistance.

According to processes comprising sintering functional ceramic powders to give shaped articles, the resistance to heat, corrosion, and oxidation, if obtained, will not be provided with complicated shapes by conventional normal-pressure sintering or HIP sintering and multi-functional shaped articles are difficult to obtain. It is more difficult in this case to obtain shaped articles having gradient functions.

SUMMARY OF THE INVENTION

An object of the present invention is to provide functional ceramic shaped articles which are superior in heat resistance, corrosion resistance, and oxidation resistance, producible by sintering with high dimensional accuracy and precision, and are provided each with at least a dielectric property.

Another object of the present invention is to provide a process for producing such functional ceramic shaped articles.

BRIEF DESCRIPTION OF THE DRAWINGS

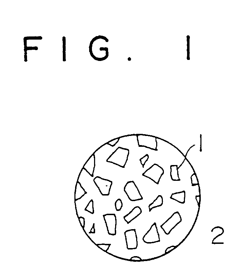

Fig. 1 is a schematic cross-sectional view of an example of the functional ceramic shaped article consisting of a sintered body produced according to this invention.

DETAILED DESCRIPTION OF THE PREFERRED EMBODIMENT

The present invention involves (i) a functional ceramic shaped article consisting of a reaction-sintered body which has high dimensional accuracy and a specific electrical property, said reaction-sintered body being formed of particles and/or fibers of at least one functional inorganic material selected from low-dielectric materials, said particles and/or fibers being bound together through a ceramic formed from a metal powder during the sintering and (ii) a process for producing such articles.

This article is a novel material that could not be obtained at all by normal-pressure sintering or HIP sintering. The present inventors have found that a functional ceramic shaped article superior in oxidation resistance and corrosion resistance can be obtained by embedding functional inorganic particles in a matrix consisting of metal particles, and reaction-sintering this matrix to convert it to a ceramic which binds together said inorganic particles, thus forming a strong sintered body, and that ceramic articles of complicated shapes can also be produced with high dimensional accuracy according to this process.

According to this invention, functional particles are bound together through an inorganic compound formed from metal particles during the sintering and thereby voids among particles are reduced. Hence the dimensional change in sintering stage can be reduced. This can be achieved by binding together particles and/or fibers (short filaments) of at least one functional inorganic compound through a nitride formed from metal particles.

Reaction products resulting from the reaction sintering according to this invention contain whiskers and/or similar particles, through which other particles can be bound strongly.

Metal particles used in this invention consist of at least one of Ti, Sr, V, Nb, Ta, Cr, Si and Al.

In this invention, existing dielectric materials may be used including $TiO_2$, $MgTiO_3$, $CaTiO_3$, $SrTiO_3$, $BaTiO_3$, and $Pb(Zr, Ti)O_3$. These dielectric materials when used provide low-dielectric or high-dielectric articles which exhibit high breakdown voltages.

The use of dielectric materials with less relative dielectric constants than 500 provides lower-dielectric articles while the use of dielectric materials with more relative dielectric constants than 500 provides higher-dielectric articles. Small-size, high-capacity, single-body laminated capacitors can be produced by sintering high-dielectric layers superposed one upon another. According to this invention, phases different in resistivity can be formed by binding together dielectric particles through a metal nitride, phase-boundary polarization can be readily achieved. Binding with an electrically conductive nitride provides highly conductive, dielectric articles.

Moreover, functionally gradient ceramic articles, wherein functions change continuously or stepwise or ceramic articles having directional functions can be produced by arranging some of the above-stated functional materials continuously or stepwise or orienting some of them, followed by reaction-sintering these arranged or oriented materials. In this invention, the dimensional change from the shaped bodies to the sintered body is minimized since the reaction-sintering method is employed.

In this invention, the porosity of functional ceramic articles is desired to be up to 40%. This is because articles having porosities exceeding 40% are inferior in various properties. The pores in the green shaped bodies need to be mainly open cells, because passages for gas need to be present in said green shaped bodies, containing metal particles, in order that intended articles may be produced by sintering said green shaped bodies in a nitriding atmosphere, thereby nitriding said metal particles. The nitriding atmosphere comprises a nitrogen-containing gas (e.g. nitrogen gas) and optionally hydrogen, oxygen, carbon monoxide, or argon gas. During the sintering, metals in a particle form may react with each other or metal particles may react with functional inorganic particles, depending on the species of metals or on the species of metal and inorganic compound, without raising any problem. For example, some TiAl, $TiAl_3$, TiSi, or ZrAl may form.

Fig. 1 is a cross-sectional view of an example of functional ceramic articles consisting of reaction-sintered bodies 1, 2 produced according to this invention.

In this invention, suitable binders for use to shape green bodies include; organic polymers, e.g. polyvinyl butyral and polyethylene; organic Si polymers, e.g. a silicon imide compound, polyethylene-polysilane compound, and polysilicone; and synthetic waxes. Such a binder is added in suitable amounts, preferably from 8 to 15 parts by weight based on the whole ingredient, thereby giving desirably a packed particle volume fraction of shaped body (percentage of volume occupied by powders based on the whole volume of body) of at least 70%.

The shaping is carried out by such a method selected from those hitherto known, including injection molding, press forming, doctor blade method, rubber press forming, extrusion forming, and metal powder forming, as to meet the shape of product, and property requirements and geometric requirements for the product.

Metals and various functional materials including fibers may be used in the form of roundish particles pulverized by using a mill or the like or in the form of granulated powders.

The process of this invention for producing functional ceramic shaped articles comprises adding a binder consisting of a thermoplastic resin to a mixture of the above-stated metal powder with the above-stated functional inorganic power, heating and kneading the whole mixture, subjecting it to hot pressing to shape an aggregate of particles with a packed particle volume fraction of at least 70%, heating the body to remove the binder, and sintering the body by heating in a nitriding gas atmosphere, thereby binding together inorganic particles through nitride particles and/or whiskers formed from the metal powder.

The above binder consisting of a thermoplastic resin is added desirably in an amount represented by

$$B = [(7S/20{,}000) + 3] \pm 2.5$$

wherein, B denotes the amount (part by weight) of binder added to 100 parts by weight of the raw material mixed powders and S denotes the specific surface area ($cm^2/g$) of the overall raw material powder, and then the whole mixture is kneaded with heating, and an aggregate of particles with a packed particle volume fraction of at least 20% is shaped from the kneaded mixture by hot press forming. In addition, the composition composed of both the powder mixture and the binder consisting of a thermoplastic resin is desired to have an apparent viscosity of (3-90) x $10^4$ N•s/$m^2$ at 150°C.

The mixing ratio of the metal powder to the whole mixture is desired to be at least 45% by volume for the purpose of minimizing the dimensional change in sintering stage and yielding sintered ceramic articles having sufficient strength.

Sintered articles having enough strength, e.g. flexural strength of about 300 MN/$m^2$ or more, can be obtained by shaping aggregates of raw material particles with packed particle volume fractions of 60% and more. Raising said packed particle volume fraction is most effective in enhancing the strength.

In this invention, the binder consisting of a thermoplastic resin plays an important role, that is, a packed volume fraction of 70% or more of the shaped aggregate of raw material particles can be achieved by adding a controlled amount of this binder.

Particle sizes of the metal powder are up to 10 $\mu$m, preferably up to 1 $\mu$m, and particle sizes of the inorganic powder are up to 100 $\mu$m, preferably up to 20 $\mu$m. These materials are used preferably in the form of roundish particles prepared by grinding with a mill or the like, though commercially available powders of suitable particle sizes may be used as such.

The inorganic powder may be replaced partly by whiskers. In this case, whiskers are blended desirably in an amount of up to 55% by volume based on the whole ingredient which will remain after sintering. When the amount thereof exceeds this limit, uniform blending of ingredients is impossible in some cases. Whiskers to be added are desired to have an average aspect ratio of up to 200 and an average length of up to 200 $\mu$m.

The ingredient mixture containing the above defined amount of binder (comprising a thermoplastic resin) has an apparent viscosity in the range of (3-90) x $10^4$ N•S/$m^2$ as will be described later. The fluidity of ingredient mixture during its shaping (before sintering) is predictable from the values of apparent viscosity. Since shaped bodies with packed volume fractions of at least 70% can be obtained by controlling the apparent viscosity within the above-defined range, compositions fitted for near net shape can be provided.

Particularly in view of the flow property of ingredient mixture, it is desirable to use an Si powder of up to 1 $\mu$m in particle size and add a binder composed of 15-60% by weight of polyethylene, 30-70% by weight of wax, and 5-25% by weight of stearic acid.

The ingredient mixture containing such a binder is thoroughly kneaded and then shaped. According to the intended shape and required properties of end product, a suitable method can be chosen from injection molding, press forming, rubber press forming, extrusion forming, in-mold powder forming, etc. In any of such methods, the kneaded mixture is warmed and shaped above the softening temperature of the binder resin. As an example, the shaping by use of a mechanical press is better carried out at a pressure of about 98.1 MPa (1000 kgf/$cm^2$).

The shaped body is then subjected to deoiling (removal of the binder) prior to sintering. The deoiling can be accomplished by heating the shaped body gradually from room temperature up to about 500°C at a rate of about 2°C/hr.

Desirably, the sintering is carried out by heating the deoiled body in a nitriding gas atmosphere composed of nitrogen and/or ammonia and if necessary, hydrogen, argon, or helium at a temperature below the melting point of the metal, particularly from 1100 to 1350°C. The optimum rate of heating to the sintering temperature is 4°C/hr. In this manner, the sintering can be accomplished with ease. If necessary, a hot press may be used.

The porosity of sintered bodies is desired to be up to 40%. When the porosity exceeds 40%, the strength is undesirably low. Lower porosities than 40% can be achieved by controlling said packed particle volume fraction of shaped bodies to at least 70%.

When Si is used as a metal ingredient, $Si_3N_4$ whiskers are produced during the sintering. The content of these whiskers is desirably from 1 to 70%, particularly from 10 to 30%, by volume based on the reaction product phase.

The following things are conceivable about the reason why the dimensional change of shaped bodies in sintering stage is minimized (about 0.15% or less) according to this invention.

That is, in the first place, nitride whiskers formed by the sintering in a nitriding atmosphere contribute greatly to the dimensional change in sintering stage. The content of these whiskers is controlled desirably within the range of 1 to 30% by volume based on the formed nitride. This whisker content depends on the amount of metal used and other factors.

When a composition of 100 parts by weight of a metal-inorganic compound mixture and 9 parts by weight of a thermoplastic resin binder is kneaded with heating and shaped by hot press forming and the shaped body is freed of the binder and sintered, the amount of whiskers and the strength of sintered body increase as the amount of metal used is increased. Simultaneously, the dimensional change in sintering stage increases but this increase is not so great as to raise a problem in practical use. This is conceivably because particles in the sintered body are strongly connected one to another through whiskers formed during the sintering.

The raw material powders themselves, consisting of fine brittle solid particles, are difficult to pack densely when compressed as such. Therefrom, it is necessary to aid the flow of these particles by adding the above-stated binder and therewith enhance the strength of shaped body. The strength of sintered body varies depending on the amount of binder added. As stated above, this strength is related to the packed volume fraction (density) of the shaped body. As the amount of binder is increased, flow properties of the mixture become better and the press forming thereof becomes easier, resulting in an increase in the packed particle volume fraction of the shaped body. When the binder is added in larger amounts than that giving the ideal densely packed state of raw material particles, these particles become in such a state as to be isolated one from another. In this case, the mixture exhibits a high fluidity, but the solid fraction of shaped body lowers excessively, that is, the volume occupied by solid particles in the shaped body reduces greatly, and as a result the sintered body has a high porosity and a low strength.

As stated above, shaped bodies of proper composition in preferred embodiments of this invention are sintered by heating in a nitriding atmosphere, whereby whiskers formed from metal particles grow three-dimensionally, connect solid particles one to another, and simultaneously fill interstices between these particles, hence yielding ceramic articles having high stiffness and toughness.

This invention is illustrated in more detail with reference to the following examples.

The specific surface area $S(cm^2/g)$ of the raw material powder can be calculated from the following formula:

$$S = \frac{6}{p \cdot d}$$

wherein p is the density $(g/cm^3)$ of powder particles and d is the average diameter (cm) of powder particles.

Example 1

Pieces were shaped from 30 wt% of an Al powder of 1 $\mu$m in average particle size and 70 wt% of a $PbTiO_3$ powder of 1 $\mu$m in average particle size with organic binders, and then heated stepwise from 400°C to 1100°C for a long time in a nitriding atmosphere, yielding sintered articles. The dielectric constant of the obtained articles was 250. The content of aluminum nitride whiskers in these sintered articles was about 5 vol. %.

Example 2

According to the procedure of Example 1, pieces were shaped from 30 wt% of a Ti powder of 1 $\mu$m in average particle size and 70 wt% of an $Al_2O_3$ powder of 1 $\mu$m in average particle size with organic binders, and heated stepwise from 400°C to 1100°C for a long time in a nitriding atmosphere, yielding sintered articles. The dielectric constant of the obtained articles was 9. The content of titanium nitride whiskers in these sintered articles was similar to that in the articles obtained in Example 1.

Example 3

4 Parts by weight each of organic binders: a polyethylene wax, other synthetic wax, and stearic acid, for shaping purposes was added to 100 parts by weight of a mixture composed of 40 wt% of a metallic Ti powder of 1 $\mu$m in average particle size and 60 wt% of a $BaTiO_3$ powder of 1 $\mu$m in average particle size. The resulting mixtures were kneaded each in a pressurized kneader at 160°C for 5 hours. These kneaded mixtures were crushed to prepare test materials. Disks of 50 mm in diameter and 20 mm in thickness were shaped from these test materials by using a mechanical press at a pressure of 98,1 MPa (1000 kgf/cm$^2$)and a temperature of 160°C. These shaped disks were found to have packed particle volume fractions of at least 60%. The shaped disks were heated up to 500°C at a heating rate of 3°C/hr in an argon atmosphere to remove the binder, and further heated stepwise from 600°C to 1300°C for a long time in a nitrogen atmosphere, yielding sintered articles. Properties of these sintered articles are shown in Table 3. Therefrom it can be seen that capacitors having low resistivity and high permittivity were obtained according to the process of this invention with low dimensional change of shaped disks in sintering stage. These shaped disks (green bodies) can also be laminated one with another and sintered. A dielectric ceramic article having a magnetic property was obtained by combining the same dielectric particles as used above with magnetic particles. Similarly, a dielectric article having a catalytic property was obtained by combining the same dielectric particles with catalytic particles. Furthermore, dielectric articles having electron emission and heat conductivity were obtained.

Table 3

| Dimensional change in sintering stage (%) | Dielectric constant | Resistivity ($\Omega$m) |
|---|---|---|
| 0.3 | 1500 | $7 \times 10^{-7}$ |

According to the present invention, it is possible to readily produce functional ceramic shaped articles by sintering shaped bodies with low dimensional change in sintering stage, the resistivity of the articles being variable from an insulator level to a conductor level, and the articles being provided with electrical and magnetic properties. Accordingly, the present ceramic articles can be used under special surrounding conditions for various applications without requiring additional processing such as cutting because of the low dimensional change in sintering stage, in other words, because the present ceramic articles are producible with high dimensional accuracy. Examples of the various applications of the present articles include capacitors.

**Claims**

1. A reaction-sintered ceramic shaped article of a material consisting essentially of particles of a nitride of at least one metal selected from the group consisting of Ti, Zr, V, Nb, Ta, Cr, Si and Al, and dielectric particles and/or whiskers having a relative dielectric constant of less than 500 and being at least one member selected from the group consisting of $TiO_2$, $MgTiO_3$, $CaTiO_3$, $SrTiO_3$ and $Pb(Zr,Ti)O_3$; said dielectric particles and/or whiskers being bonded together through the above said nitride particles formed from the above said metal during the sintering.

2. A process for producing the ceramic shaped articles according to Claim 1, which comprises (i) mixing at least a powder of a metal selected from the group consisting of Ti, Zr, V, Nb, Ta, Cr, Si and Al, and dielectric particles and/or whiskers having a relative dielectric constant of less than 500 and being at least one member selected from the group consisting of $TiO_2$, $MgTiO_3$, $CaTiO_3$, $SrTiO_3$ and $Pb(Zr,Ti)$-$O_3$, (ii) adding a binder consisting of a thermoplastic resin to a mixture of the above-stated metal powder with the above-stated dielectric particles and/or whiskers (iii) heating and kneading the whole mixture (iv) shaping it (v) heating the body to remove the binder, and (vi) sintering the body by heating in a nitriding gas atmosphere, thereby binding together the dielectric particles through nitride particles formed from the metal powder during sintering.

3. A low resistivity and high permittivity capacitor consisting of a reaction-sintered ceramic shaped body consisting essentially of titanium nitride and dielectric particles of BaTiO$_3$ said dielectric particles being bonded together through the titanium nitride particles formed during the sintering.

**Patentansprüche**

1. Reaktionsgesinterter keramischer Formkörper aus einem Material, das im wesentlichen aus Teilchen eines Nitrids wenigstens eines aus der aus Ti, Zr, V, Nb, Ta, Cr, Si und Al bestehenden Gruppe gewählten Metalls und dieelektrischen Teilchen und/oder Whiskern, die eine relative Dielektrizitätskonstante von weniger als 500 haben und wenigstens ein aus der aus TiO$_2$, MgTiO$_3$, CaTiO$_3$, SrTiO$_3$ und Pb(Zr,Ti)O$_3$ bestehenden Gruppe gwähltes Glied sind, welche dielektrischen Teilchen und/oder Whisker durch die aus dem oben genannten Metall während des Sinterns gebildeten, obengenannten Nitridteilchen miteinander verbunden sind.

2. Verfahren zur Herstellung der keramischen Formkörper nach Anspruch 1; das
   (i) Vermischung wenigstens eines Pulvers eines aus der aus Ti, Zr, V, Nb, Ta, Cr, Si und Al bestehenden Gruppe gewählten Metalls und dielektrischer Teilchen und/oder Whisker, die eine relative Dielektrizitätskonstante von weniger als 500 haben und wenigstens ein aus der aus TiO$_2$, MgTiO$_3$, CaTiO$_3$, SrTiO$_3$ und Pb(Zr,Ti)O$_3$ bestehenden Gruppe gewähltes Glied sind,
   (ii) Zusatz eines aus einem thermoplastischen Harz bestehenden Bindemittels zu einer Mischung des oben angegebenen Metallpulvers mit den obenangegebenen dielektrischen Teilchen und/oder Whiskern,
   (iii) Erhitzen und Kneten der ganzen Mischung,
   (iv) deren Formung,
   (v) Erhitzen des Körpers zur Entfernung des Bindemittels, und
   (vi) Sintern des Körpers durch Erhitzen in einer nitrierenden Gasatmosphäre umfaßt, wodurch die dielektrischen Teilchen durch aus dem Metallpulver während des Sinterns gebildete Nitridteilchen miteinander verbunden werden.

3. Kondensator niedrigen Widerstands und hoher Dielektrizitätskonstante, der aus einem reaktionsgesinterten keramischen Formkörper besteht, der im wesentlichen aus Titannitrid und dielektrischen BaTiO$_3$-Teilchen zusammengesetzt ist, welche dielektrischen Teilchen durch die während des Sinterns gebildeten Titannitridteilchen miteinander verbunden sind.

**Revendications**

1. Article moulé en céramique formé par frittage-réaction d'un matériau constitué essentiellement en particules d'un nitrure d'au moins un métal choisi dans le groupe comprenant Ti, Zr, V, Nb, Ta, Cr, Si et Al, et des particules diélectriques et/ou des whiskers possédant une constante diélectrique relative inférieure à 500, et étant au moins un élément choisi dans le groupe comprenant TiO$_2$, MgTiO$_3$, CaTiO$_3$, SrTiO$_3$, Pb(Zr,Ti)O$_3$; lesdites particules diélectriques et/ou whiskers étant réunies au moyen desdites particules de nitrure indiquées précédemment, formées à partir dudit métal indiqué précédemment au cours du frittage.

2. Procédé pour fabriquer des articles moulés céramiques selon la revendication 1, qui consiste à (i) mélanger au moins une poudre d'un métal choisi dans le groupe comprenant Ti, Zr, V, Nb, Ta, Cr, Si et Al, et des particules diélectriques et/ou des whiskers possédant une constante diélectrique relative inférieure à 500, et étant au moins un élément choisi dans le groupe comprenant TiO$_2$, MgTiO$_3$, CaTiO$_3$, SrTiO$_3$, Pb(Zr,Ti)O$_3$, (ii) ajouter un liant constitué par une résine thermoplastique à un mélange de la poudre métallique indiquée précédemment avec les particules diélectriques et/ou whiskers indiquées précédemment, (iii) chauffer et malaxer l'ensemble du mélange, (iv) le mettre en forme, (v) chauffer le corps pour éliminer le liant, et (vi) fritter le corps par chauffage dans une atmosphère de gaz nitrurant, de manière à réunir entre elles les particules diélectriques par l'intermédiaire de particules de nitrure formées à partir de la poudre métallique au cours du frittage.

3. Condensateur à faible résistivité et haute permitivité constitué par un corps moulé en céramique formé par frittage-réaction, constitué essentiellement par du nitrure de titane et des particules diélectriques de BaTiO$_3$, lesdites particules diélectriques étant réunies entre elles par l'intermédiaire des particules de nitrure de titane formées pendant le frittage.

# F I G .  I